# FASCICULE DE BREVET EUROPEEN

(11) **EP 2 351 143 B1**
(45) Date de publication et mention de la délivrance du brevet: **21.11.2012**
(21) Numéro de dépôt: 09736892.2
(22) Date de dépôt: 08.10.2009
(51) Int. Cl.: H01P 5/18, H01P 7/08

(54) **COUPLEUR RADIOFREQUENCE COMPACT**
KOMPAKTER HOCHFREQUENZKOPPLER
COMPACT RADIOFREQUENCY COUPLER

(30) Priorité: 25.11.2008 FR 0806618
(43) Date de publication de la demande: 03.08.2011
(73) Titulaire: THALES, 92200 Neuilly-sur-Seine (FR)
(72) Inventeur: BERTRAM, Pierre, F-49510 Jallais (FR)
(74) Mandataire: Collet, Alain
(86) Numéro de dépôt international: PCT/EP2009/063077
(87) Numéro de publication internationale: WO 2010/060675

(56) Documents cités:
- US-A- 5 557 245
- US-A- 6 114 924
- US-A1- 2004 207 482
- US-A1- 2005 077 993

## Description

La présente invention concerne un coupleur radiofréquence compact. Elle s'applique notamment pour la réalisation d'émetteurs radiofréquences à bas coût.

Les coupleurs de puissance, notamment bidirectionnels, utilisés dans des émetteurs radiofréquences, permettent de contrôler la puissance émise en prélevant une fraction du signal. A cet effet, ils sont par exemple disposés en sortie d'un amplificateur de puissance. Les coupleurs bidirectionnels permettent de contrôler à la fois la puissance incidente d'entrée et la puissance réfléchie par une charge, par exemple une antenne. Les coupleurs de puissance bidirectionnels ont communément pour fonction de coupler une ligne secondaire - ou ligne de mesure - à la ligne de transmission par l'intermédiaire de transformateurs.

On trouve donc notamment des coupleurs de puissance bidirectionnels en sortie d'amplificateurs RF ou hyperfréquences, par exemple sur des cartes d'amplification équipant des transmetteurs radio et terminaux HF, avec des fréquences de fonctionnement de l'ordre du MHz à quelques dizaines de MHz, ou bien dans des transmetteurs de radar fonctionnant dans des gammes de fréquences bien plus élevées.

L'utilisation de tels coupleurs permet de contrôler le bon fonctionnement des amplificateurs, en diagnostiquant la présence ou l'absence de puissance de sortie, ou encore de déterminer un taux d'onde stationnaire - ou T.O.S. - par une mesure de la puissance réfléchie. De telles informations permettent de déclencher d'éventuelles alertes en cas de dysfonctionnement, voire de réaliser un asservissement des paramètres de fonctionnement en fonction de la charge.

Des coupleurs de puissance bidirectionnels ont été proposés, utilisant des transformateurs réalisés par des bobinages filaires sur des noyaux de matériaux ferromagnétiques. Notamment, il a été proposé un coupleur de puissance bidirectionnel comprenant un noyau de ferrite à deux cavités cylindriques, ou noyau de ferrite binoculaire, chacune de ces cavités étant enroulée par un bobinage filaire, le bobinage s'étendant ainsi sur la surface interne des cavités et la surface externe du noyau de ferrite. Le document US 2005/0077993 décrit un circuit coupleur RF. Le brevet américain publié sous la référence US 6,114,924 propose une construction alternative d'un tel coupleur, présentant deux noyaux de ferrite binoculaires placés dos à dos, permettant au bobinage de s'étendre essentiellement sur la surface interne des cavités.

Cependant de telles structures de coupleurs sont réalisées de manière artisanale, ce qui impacte essentiellement leur coût de fabrication, et éventuellement la reproductibilité et la tenue des performances, notamment en termes de pertes et de directivité de couplage. Par ailleurs, cette réalisation impose un report et un brasage manuels du coupleur sur la carte qu'il équipe.

Un but de l'invention est de pallier les inconvénients précités, en proposant un coupleur de puissance bidirectionnel réalisable de manière industrielle, à moindre coût, et présentant une intégration aisée. A cet effet, l'invention a pour objet un coupleur bidirectionnel comprenant une ligne principale de transmission et une ligne de mesure couplée à la ligne de transmission au moyen de deux bobinages enroulés autour d'un noyau de ferrite, caractérisé en ce que lesdits bobinages sont de structure planaire et réalisés dans une carte de circuit imprimé.

Selon un mode de réalisation de l'invention, la ligne principale de transmission, la ligne de mesure et les bobinages sont réalisés par une technique de type micro-ruban multicouche.

Selon un mode de réalisation de l'invention, les bobinages entourent un unique noyau de ferrite binoculaire de structure planaire.

Selon un mode de réalisation de l'invention, le noyau de ferrite binoculaire est disposé en surface de la carte de circuit imprimé, et présente la forme d'un E, la branche centrale du E étant disposée entre la ligne principale de transmission et la ligne de mesure, les branches distales du E étant disposées dans la région centrale des bobinages planaires.

Selon un mode de réalisation de l'invention, le noyau de ferrite binoculaire est fixé sur la carte de circuit imprimé au moyen d'un support et d'une pièce de fixation par clipsage.

Selon un mode de réalisation de l'invention, le noyau de ferrite binoculaire est fixé sur la carte de circuit imprimé par collage.

L'invention a également pour objet un émetteur radiofréquence comportant un coupleur radiofréquence tel que décrit plus haut.

D'autres caractéristiques et avantages de l'invention apparaîtront à la lecture de la description qui suit, donnée à titre d'exemple, faite en regard des dessins annexés qui représentent :
- la figure 1, le schéma électrique d'un exemple de coupleur selon l'invention ;
- les figures 2 et 3, une illustration d'exemples de structures de coupleurs hyperfréquences connus de l'état de la technique ;
- la figure 4, une représentation schématique d'un exemple de coupleur selon l'invention, en vue de dessus ;

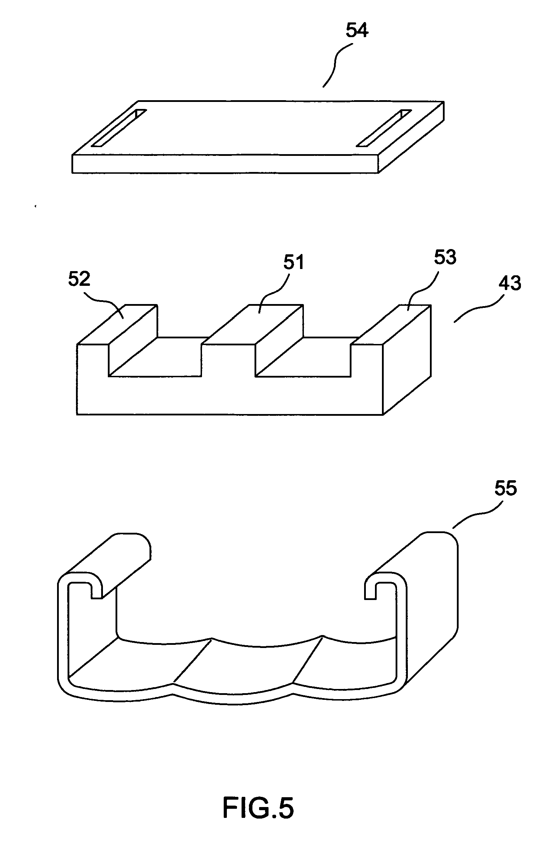

- la figure 5, une vue en perspective d'un noyau de ferrite selon un exemple de réalisation de l'invention.

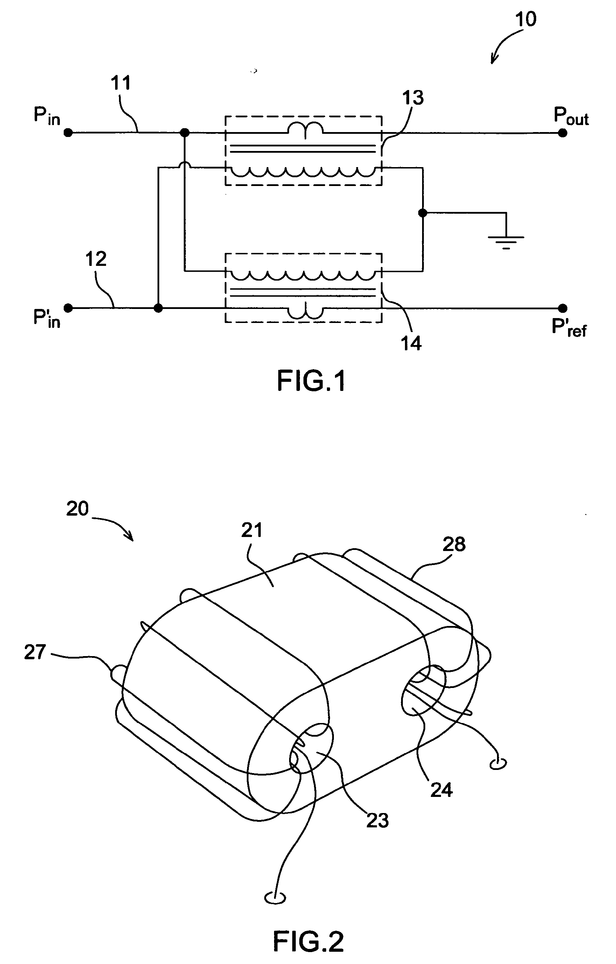

La figure 1 présente le schéma électrique d'un coupleur hyperfréquence bidirectionnel 10, connu de l'homme du métier. Le coupleur présente une ligne de transmission principale 11, une ligne de mesure 12, la ligne de mesure 12 étant couplée à la ligne de transmission 11 par l'intermédiaire de deux transformateurs 13 et 14 dont les rôles sont de prélever le courant et la tension, ces deux transformateurs étant interconnectés pour assurer la symétrisation du circuit. Le coupleur présente une entrée Pin par exemple connectée à la sortie d'un amplificateur, une sortie Pout connectée à une charge, une sortie P'in et une sortie P'ref, connectées à des moyens de mesure. La puissance incidente (par exemple la puissance de sortie de l'amplificateur) entre dans le coupleur en Pin, une partie de la puissance incidente est prélevée et dirigée vers la sortie couplée P'in, la majeure partie restante de la puissance incidente étant dirigée via la ligne de transmission 11 vers la sortie Pout. La puissance réfléchie par la charge entre en Pout et est dirigée vers la sortie isolée P'ref. Ainsi la mesure de la puissance en P'in permet une estimation de la puissance incidente sans avoir altéré significativement la puissance du signal transmis entre l'entrée Pin et la sortie Pout. De la même manière, une mesure de la puissance en P'ref permet une estimation de la puissance réfléchie au niveau de la charge.

La figure 2 présente une structure de coupleur 20 connue de l'état de la technique, dont le schéma électrique de la figure 1 est représentatif. Dans cette structure de coupleur, des bobinages filaires 27 et 28 sont réalisés autour d'un unique noyau de ferrite 21 à deux cavités cylindriques 23 et 24, dit "noyau de ferrite binoculaire". Le coupleur peut être ensuite rapporté sur une carte de circuit imprimé, et les terminaux des fils de bobinages connectés par soudure aux pistes adéquates.

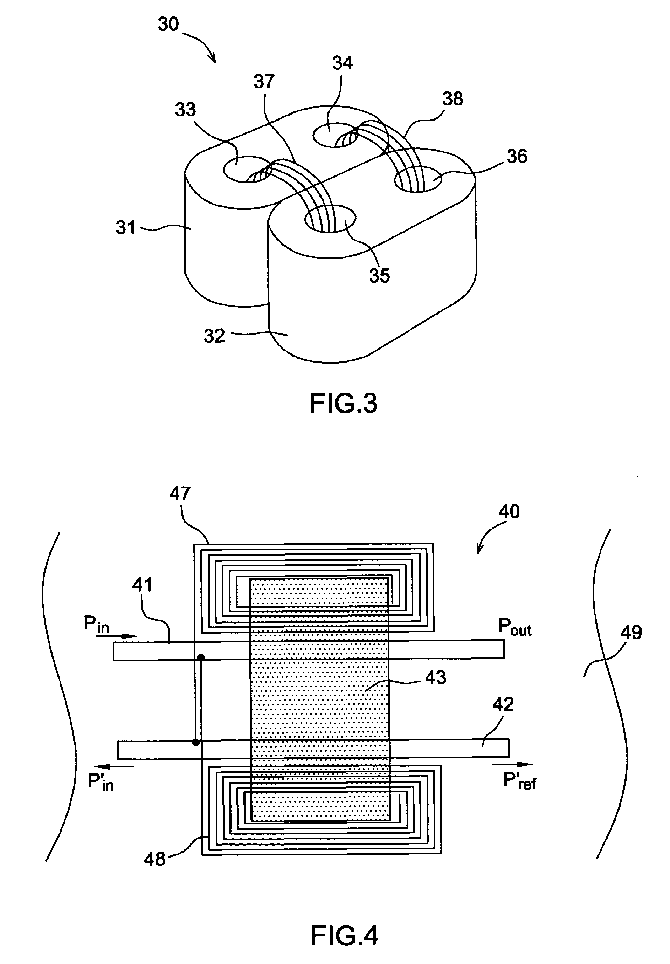

La figure 3 présente une structure de coupleur 30 selon l'invention décrite dans le brevet américain précité, publié sous la référence US 6,114,924, apportant une amélioration à la structure décrite par la figure 2, notamment en procurant un meilleur affaiblissement en réflexion et une meilleure stabilité dans le temps des performances. Dans cette structure de coupleur, les bobinages filaires 37 et 38 sont réalisés autour de deux noyaux de ferrite binoculaires 31 et 32 placés dos à dos en contact l'un avec l'autre. Chaque bobinage est réalisé autour de la cavité cylindrique d'un des deux noyaux de ferrite et de la cavité cylindrique de l'autre noyau de ferrite, en regard de la première cavité cylindrique. Par exemple, le bobinage 37 est réalisé en procédant à un enroulement partant du bas de la cavité cylindrique 33 du noyau de ferrite 31, pénétrant par le haut la cavité cylindrique 35 du noyau de ferrite 32 puis à nouveau la cavité cylindrique 33 par le bas, etc. pour finalement, une fois le nombre d'enroulements désiré atteint, ressortir par le bas de la cavité cylindrique 35. De la même manière, le bobinage 38 est réalisé en procédant à un enroulement le long des génératrices des cavités cylindriques 34 et 36 des noyaux de ferrite 31 et 32 respectivement.

Les structures de coupleurs représentées dans les figures 2 et 3 décrites plus haut, présentent quelques inconvénients. Notamment, de telles structures doivent être réalisées de manière artisanale ; ainsi la qualité des enroulements est dépendante des opérateurs, impactant la reproductibilité des performances de ces coupleurs. En outre, l'intégration de tels coupleurs sur des cartes de circuits imprimés, et dans des postes de télétransmission HF est généralement artisanale, avec la réalisation de plusieurs brasures. Enfin et par conséquent, la fabrication et le report de tels coupleurs représentent un coût significatif en regard du coût total des cartes qui en sont équipées.

La figure 4 représente un coupleur 40 selon l'invention. L'exemple de structure de coupleur selon l'invention pallie les problèmes cités précédemment. Les bobinages 47 et 48 sont des bobinages planaires réalisés sur une carte de circuit imprimé 49. La ligne de transmission 41 et la ligne de mesure 42 sont réalisées sous la forme de pistes imprimées sur la même carte. Selon un mode de réalisation de l'invention, les pistes imprimées sont réalisées par la technologie dite micro-ruban ou "microstrip" permettant de réaliser des guides d'ondes multicouches sur des substrats de cartes de circuits imprimés. Selon un mode de réalisation préférentiel de l'invention, les bobinages planaires sont réalisés sur plusieurs couches et reliés par des vias, afin de maximiser le nombre de spires tout en préservant une surface réduite sur la carte de circuit imprimé. Un couplage magnétique est assuré entre la ligne de transmission 41 et le bobinage 47 en regard. De la même manière, un couplage magnétique est assuré entre la ligne de mesure 42 et le bobinage 48 en regard. Par exemple, pour prélever un signal sur la ligne de transmission qui soit atténué de -22 dB, il est possible de produire sur 4 couches superposées, des enroulements de 3 spires. Afin de guider les lignes de champ magnétique tout en minimisant les pertes, il est nécessaire de recourir à un noyau de ferrite. Selon un mode de réalisation préférentiel de l'invention, un noyau de ferrite binoculaire 43 de structure essentiellement planaire est utilisée. Un noyau de ferrite standard (Commercial Off-The-Shelf) Manganèse-Zinc dédié à des transformateurs ou bobines pour alimentation à découpage fonctionnant dans des fréquences jusque 1 MHz et présentant une perméabilité magnétique sensiblement égale à 900 jusqu'à ces fréquences, peut être utilisé. Ce type de noyau de ferrite présente l'avantage d'être disponible dans le commerce de façon standard, donc à un faible coût. Selon un mode préférentiel de l'invention, le noyau de ferrite 43 présente une structure en E. Ainsi, la branche centrale 51 du E est disposée entre la ligne de transmission 41 et la ligne de mesure 42, et les branches distales 52 et 53 du E dans la région centrale des bobinages planaires 47 et 48. Selon un mode de réalisation préférentiel de l'invention, les trois branches du E 51, 52 et 53 traversent des trous appropriés réalisés dans la carte de circuit imprimé, permettant ainsi la fixation du noyau de ferrite sur la carte de circuit imprimé, en utilisant par exemple un élément de support 54 disposé sur la face opposée de la carte de circuit imprimé, et un moyen de fixation 55 par clipsage. Selon un mode alternatif de réalisation de l'invention, le noyau de ferrite peut être fixé sur la carte de circuit imprimé par collage. Il est bien entendu que l'homme du métier pourra envisager toute autre technique connue de fixation.

Les avantages procurés par la structure de coupleur bidirectionnel décrite plus haut apparaissent clairement à l'homme du métier, cette structure dispensant le report et le brasage de composants sur la carte de circuit imprimé, sur laquelle à la fois la ligne de transmission, la ligne de mesure et les bobinages ainsi que leurs interconnexions sont imprimés, le tout pouvant être réalisé dans un volume réduit et à moindre coût, avec une parfaite reproductibilité et une bonne stabilité dans le temps des performances. En outre, l'utilisation d'un noyau de ferrite standard et à bas coût permet de réduire le coût global du coupleur. Par exemple, un tel coupleur utilisé typiquement dans un transmetteur HF, pour des puissances de l'ordre du Watt à quelques dizaines de Watts, et une fréquence de fonctionnement comprise entre 1 MHz et quelques dizaine de MHz, peut raisonnablement être réalisé sur une surface de carte de l'ordre de 3 centimètres carrés.

## Revendications

1. Coupleur radiofréquence (40) de puissance bidirectionnel comprenant une ligne principale de transmission (41) et une ligne de mesure (42) couplée à la ligne de transmission au moyen de deux bobinages (47, 48) enroulés autour d'un noyau de ferrite (43), **caractérisé en ce que** lesdits bobinages sont de structure planaire et réalisés dans une carte de circuit imprimé (49).

2. Coupleur radiofréquence (40) selon la revendication 1, **caractérisé en ce que** la ligne principale de transmission (41), la ligne de mesure (42) et les bobinages (47, 48) sont réalisés par technique de type micro-ruban multicouche.

3. Coupleur radiofréquence (40) selon la revendication 1, **caractérisé en ce que** lesdits bobinages (47, 48) entourent un unique noyau de ferrite binoculaire (43) de structure planaire.

4. Coupleur radiofréquence (40) selon la revendication 3, **caractérisé en ce que** ledit noyau de ferrite binoculaire (43) est disposé en surface de la carte de circuit imprimé (49), et présente la forme d'un E, la branche centrale (51) du E étant disposée entre la ligne principale de transmission (41) et la ligne de mesure (42), les branches distales (52, 53) du E étant disposées dans la région centrale des bobinages planaires (47, 48).

5. Coupleur radiofréquence (40) selon l'une des revendications 3 et 4, **caractérisé en ce que** ledit noyau de ferrite binoculaire (43) est fixé sur la carte de circuit imprimé (49) au moyen d'un support (54) et d'une pièce de fixation (55) par clipsage.

6. Coupleur radiofréquence (40) selon l'une des revendications 3 et 4, **caractérisé en ce que** ledit noyau de ferrite binoculaire (43) est fixé sur la carte de circuit imprimé (49) par collage.

7. Emetteur radiofréquence, **caractérisé en ce qu'**il comporte un coupleur radiofréquence (40) selon l'une des revendications précédentes.

## Claims

1. A bidirectional radiofrequency power coupler (40) comprising a main transmission line (41) and a measuring line (42) coupled to the transmission line by means of two coils (47, 48) wound around a ferrite core (43), **characterised in that** said coils are of planar structure and are realised in a printed circuit board (49).

2. The radiofrequency coupler (40) according to claim 1, **characterised in that** the main transmission line (41), the measuring line (42) and the coils (47, 48) are realised using a multilayer micro-strip type technique.

3. The radiofrequency coupler (40) according to claim 1, **characterised in that** said coils (47, 48) surround a single binocular ferrite core (43) of planar structure.

4. The radiofrequency coupler (40) according to claim 3, **characterised in that** said binocular ferrite core (43) is disposed on the surface of the printed circuit board (49) and is E-shaped, the central branch (51) of the E being disposed between the main transmission line (41) and the measuring line (42), the distal branches (52, 53) of the E being disposed in the central region of the planar coils (47, 48).

5. The radiofrequency coupler (40) according to any one of claims 3 to 4, **characterised in that** said binocular ferrite core (43) is fixed to the printed circuit board (49) by means of a support (54) and a clip-on fixing piece (55).

6. The radiofrequency coupler (40) according to any one of claims 3 to 4, **characterised in that** said binocular ferrite core (43) is fixed to the printed circuit board (49) by bonding.

7. A radiofrequency emitter, **characterised in that** it comprises a radiofrequency coupler (40) according to any one of the preceding claims.

## Patentansprüche

1. Bidirektionaler Funkfrequenz- Leistungskoppler (40), der eine Hauptübertragungsleitung (41) und eine Messleitung (42) umfasst, die mittels zweier um einen Ferritkern (43) gewickelter Spulen (47, 48) mit der Übertragungsleitung gekoppelt ist, **dadurch gekennzeichnet, dass** die Spulen eine planare Struktur haben und in einer Leiterplatte (49) realisiert sind.

2. Funkfrequenzkoppler (40) nach Anspruch 1, **dadurch gekennzeichnet, dass** die Hauptübertragungsleitung (41), die Messleitung (42) und die Spulen (47, 48) mit einer Multischichttechnik des Mikrostreifentyps realisiert sind.

3. Funkfrequenzkoppler (40) nach Anspruch 1, **dadurch gekennzeichnet, dass** die Spulen (47, 48) einen einzigen binokularen Ferritkern (43) einer planaren Struktur umgeben.

4. Funkfrequenzkoppler (40) nach Anspruch 3, **dadurch gekennzeichnet, dass** der binokulare Ferritkern (43) auf der Oberfläche der Leiterplatte (49) angeordnet und E-förmig ist, wobei der mittlere Schenkel (51) des E zwischen der Hauptübertragungsleitung (41) und der Messleitung (42) angeordnet ist, wobei die distalen Schenkel (52, 53) des E in der mittleren Region der planaren Spulen (47, 48) angeordnet sind.

5. Funkfrequenzkoppler (40) nach Anspruch 3 oder 4, **dadurch gekennzeichnet, dass** der binokulare Ferritkern (43) mittels eines Trägers (54) und eines aufsteckbaren Befestigungsstücks (55) an der Leiterplatte (49) befestigt ist.

6. Funkfrequenzkoppler (40) nach Anspruch 3 oder 4, **dadurch gekennzeichnet, dass** der binokulare Ferritkern (43) durch Kleben an der Leiterplatte (49) befestigt ist.

7. Funkfrequenzsender, **dadurch gekennzeichnet, dass** er einen Funkfrequenzkoppler (40) nach einem der vorherigen Ansprüche umfasst.
